# EUROPÄISCHE PATENTANMELDUNG

(11) **EP 1 240 968 A1**
(43) Veröffentlichungstag der Anmeldung: **18.09.2002**
(21) Anmeldenummer: 02001318.1
(22) Anmeldetag: 18.01.2002
(51) Int. Cl.: B23K 1/002, H01R 43/02, H01R 4/02, H01R 12/10

(54) **Verfahren zur Herstellung einer elektrischen Verbindung mittels Induktionslöten**

(30) Priorität: 16.02.2001 DE 10107735; 07.09.2001 DE 10143907
(71) Anmelder: Hirschmann Austria GmbH, 6830 Rankweil-Brederis (AT)
(72) Erfinder: Kreuter, Markus, 6845 Hohenems (AT); Reiss, Thomas, 6830 Rankweil/Brederis (AT); Feder, Roland, 6820 Gurtis (AT)
(74) Vertreter: Thul, Hermann, Dipl.-Phys.

(57) **Zusammenfassung**

Die Erfindung betrifft ein Verfahren zur Herstellung einer elektrischen Verbindung zwischen zwei elektrisch leitenden Kontaktpartnern (1,3), wobei erfindungsgemäß vorgesehen ist, daß die in einem Gehäuse (8) angeordneten Kontaktpartner (1,3) in einem Kontaktbereich (5) auf einer Auflage (6) innerhalb des Gehäuses (8) zusammengebracht und im Kontaktbereich (5) vorhandenes Lötzinn durch ein Induktionsfeld zum Schmelzen gebracht wird.

## Beschreibung

Die Erfindung betrifft ein Verfahren sowie eine Anwendung des Verfahrens gemäß den jeweiligen Oberbegriffen der unabhängigen Patentansprüche.

Es sind schon Verfahren zur Herstellung einer elektrischen Verbindung zwischen zwei elektrisch leitenden Kontaktpartnern bekannt, bei denen die zu kontaktierenden Bereiche der Kontaktpartner durch eine Hitzequelle (z. B. Lötkolben) unter Zugabe von Lötzinn oder dergleichen miteinander verlötet werden.

Ebenso können die Kontaktpartner dadurch miteinander verbunden werden, daß sie durch ein Lotbad bewegt werden.

Ebenso ist es bekannt, die Kontaktpartner in ihrem Kontaktbereich durch Erhitzung mittels eines Laserstrahles zu verbinden.

Bei den eingangs geschilderten Verfahren ist es erforderlich, daß der Kontaktbereich, in dem die Kontaktpartner miteinander verbunden werden sollen, von außen zugänglich ist.

Neben dem Verlöten der Kontaktpartner besteht grundsätzlich die Möglichkeit einer mechanischen Verbindung (wie z. B. Crimpen), die jedoch den Nachteil hat, daß sich die Verbindung bei rauhen Umgebungsbedingungen, wie insbesondere Vibrationen, lösen kann.

Der Erfindung liegt daher die Aufgabe zugrunde, ein Verfahren zur Herstellung einer elektrischen Verbindung sowie eine Anwendung des Verfahrens anzugeben, bei der die eingangs geschilderten Nachteile vermieden werden.

Diese Aufgabe ist durch die Merkmale der unabhängigen Patentansprüche gelöst.

Das erfindungsgemäße Verfahren ist dadurch gekennzeichnet, daß die (insbesondere in einem Gehäuse angeordneten) Kontaktpartner in einem Kontaktbereich (insbesondere auf einer Auflage innerhalb des Gehäuses) zusammengebracht und im Kontaktbereich vorhandenes Lotmaterial, insbesondere Lötzinn, durch ein Induktionsfeld zum Schmelzen gebracht wird. Daraus ergeben sich mehrere Vorteile. Zum einen können die Kontaktpartner schon vor dem Verlöten in dem Gehäuse angeordnet und fixiert werden, so daß sich während des eigentlichen Lötvorgangs (Induktionslöten) die Kontaktpartner nicht mehr bewegen, d. h., nicht mehr ihre Lage verändern können. Damit entfallen Hilfsmittel zur Lagefixierung der beteiligten Kontaktpartner. Mittels des Lötvorgangs wird eine elektrische Verbindung hergestellt, die zuverlässig ist und auch rauhen Umgebungsbedingungen standhält. Außerdem ist diese Lötverbindung durch das Gehäuse vor äußeren Einflüssen (wie insbesondere Feuchtigkeit oder elektrisch leitende Partikel, die bei nebeneinanderliegenden Kontaktpartnern zu einem Kurzschluß führen könnten) wirksam geschützt. Durch das Induktionslöten ist es nicht mehr erforderlich, daß der Kontaktbereich von außen zugänglich ist, sondern schon vor dem Löten komplett verschlossen werden kann. Aufgrund des Induktionslötens ist weiterhin der Vorteil gegeben, daß der Kontaktbereich, in dem sich die zu verbindenden Kontaktpartner befinden, innerhalb kürzester Zeit erwärmt wird, so daß sich auch die Zeit für den Verbindungsprozeß verringert. Außerdem ist es nicht erforderlich, den Kontaktbereich innerhalb des Induktionsfeldes an einer vorgegebenen Stelle zu positionieren, da aufgrund des Induktionsfeldes und der beteiligten Materialien nur der Kontaktbereich erhitzt wird. Weitere Sicherheitsmaßnahmen während des Induktionslötens können entfallen, die beispielsweise beim Laserschweißen erforderlich wären.

Das Induktionslöten erfolgt beispielsweise derart, daß eine Induktionsspule vorhanden ist, die ein Induktionsfeld (magnetisches Feld) erzeugt. Dieses Feld wird dadurch erzeugt, daß eine elektrische Wechselspannung mit Hochfrequenz in die Induktionsspule eingespeist wird. Um diese Induktionsspule herum entsteht dann das Induktionsfeld, durch welches der Kontaktbereich durchgeführt werden muß, um die dort befindlichen Kontaktpartner durch Erhitzung des dort befindlichen Lötzinnes zu verbinden. Das erforderliche Lötzinn (oder ein gleichwirkendes Mittel) ist dadurch vorhanden, daß zumindest ein Kontaktpartner vor dem Löten verzinnt wird oder daß im Kontaktbereich ein Reservoir mit Lötzinn vorhanden ist.

In einer weiteren Ausgestaltung der Erfindung sind die Kontaktpartner während des Lötvorganges einem Druck ausgesetzt. Durch diesen Druck kommen die Kontaktpartner auf der Auflage und/oder untereinander zur Anlage, so daß eine hochfeste Lötverbindung erzielt wird. Der Druck kann dadurch erzeugt werden, daß die Kontaktpartner durch eine äußere Kraft während des Induktionslötens zusammengedrückt werden. Diese äußere Kraft kann nach Abschluß des Lötvorganges weggenommen werden. Darüber hinaus ist es denkbar, daß die äußere Kraft (Druck) durch in oder an dem Gehäuse angeordnete Druckelemente, ggf. im Zusammenspiel mit der Auflage, erzeugt werden. Diese Druckelemente sind Bestandteil des Gehäuses oder bilden einzelne Bauteile (wie beispielsweise Federn oder dergleichen).

In Weiterbildung der Erfindung wird vor dem Löten zumindest um den Kontaktbereich herum das Gehäuse angebracht. Das einteilige oder auch mehrteilige Gehäuse dient der Fixierung der Kontaktpartner und kann, wenn beispielsweise einer der Kontaktpartner ein Stecker oder eine Buchse ist, gleichzeitig auch als Steckverbindergehäuse dienen. Auf diese Art und Weise werden die zu verbindenden Kontaktpartner, d. h. die Verbindungsstelle, vorkonfektioniert, so daß sie nur noch dem Induktionsfeld zum Verlöten der beiden Kontaktpartner ausgesetzt werden müssen. Eine Zugänglichkeit von außen des Kontaktbereiches ist damit auf keinen Fall erforderlich. Das Gehäuse kann aus vorgefertigten Teilen bestehen, in welche die Kontaktpartner eingesetzt werden. Denkbar ist auch, daß die Kontaktpartner fixiert und zumindest der Kontaktbereich, ggf. auch ein weiterer Bereich der Kontaktpartner, mit einem Kunststoff umspritzt werden.

Bei den zu verbindenden Kontaktpartnern handelt es sich z. B. um Stecker oder Buchsen, Kontaktstifte oder dergleichen und ebenso um elektrische Leiter, wie z. B. Rundkabel mit starrer oder flexibler Litze, um starre oder flexible Flachbandleiter, um in Kunststoff eingebettete Stanzgitter oder dergleichen usw. Mit dem erfindungsgemäßen Verfahren sind reine Verbindungsstellen herstellbar, während gleichzeitig aber auch Steckverbinder hergestellt werden können. Diese Verbindungsstellen oder die Steckverbinder bestehen aus nur einem Stecker oder einer Buchse, die mit einem Kabel oder einem Flachleiter verbunden werden oder auch aus mehreren, nebeneinanderliegenden Steckern, Buchsen oder elektrischen Leitern. Bei den Kontaktpartnern kann es sich auch um MID-Teile (Molded Interconnected Devices) handeln.

In einer besonders vorteilhaften Ausgestaltung wird das erfindungsgemäße Verfahren bei Steckverbindern oder bei der Verbindung von elektrischen Leitern, wie insbesondere Flachbandleitungen, in der Fahrzeugtechnik, insbesondere im Automobilbereich, angewendet. Diese Anwendung ist deshalb besonders vorteilhaft, weil auf einfache Art und Weise ein Steckverbinder oder eine Verbindung von Leitern hergestellt werden kann, die den Umgebungsbedingungen in der Fahrzeugtechnik (wie insbesondere Feuchtigkeit, schwankende Temperaturen, Vibrationen und dergleichen) standhält. Einerseits sind die beteiligten Kontaktpartner zuverlässig durch das Gehäuse lagefixiert und vor äußeren Einflüssen geschützt, während zum anderen durch die Lötverbindung diese äußerst zuverlässig und langzeitstabil ist.

Zwei Ausführungsbeispiele, die nach dem erfindungsgemäßen Verfahren hergestellt sind, sind im folgenden beschrieben und anhand der Figuren erläutert.

Es zeigen:
- Figur 1: eine elektrische Verbindung zwischen einem Kabel und einem Flachleiter,
- Figuren 2 bis 4: weitere Ausgestaltungen einer elektrischen Verbindung zwischen einem Stecker und einem Flachleiter.

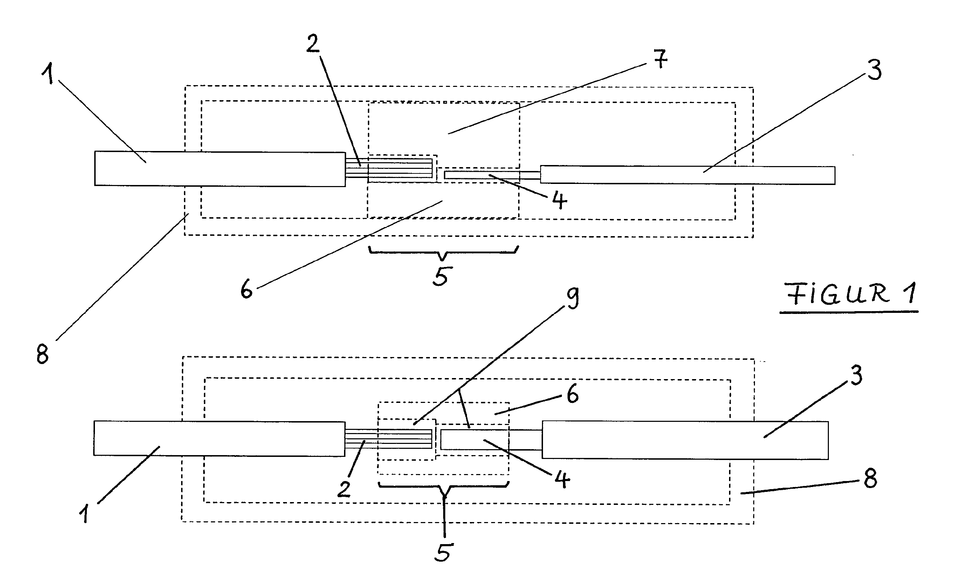

Figur 1 zeigt eine elektrische Verbindung, die nach dem erfindungsgemäßen Verfahren hergestellt ist. Bei den beiden Kontaktpartnern handelt es sich zum einen um ein Kabel 1 mit seiner innenliegenden Litze 2 sowie um einen Flachleiter 3 mit einer Leiterbahn 4. Der Flachleiter 3 kann starr oder flexibel sein, wobei innerhalb des Flachleiters 3 eine Leiterbahn 4 oder auch mehrere, parallel liegende Leiterbahnen angeordnet sind. Die Endbereiche der Litze 2 bzw. der Leiterbahn 4 stoßen in einem Kontaktbereich 5 stumpf aufeinander, wobei die Litze 2 sowie die Leiterbahn 4 auf einer nicht leitenden Auflage 6 (insbesondere aus Kunststoff) aufliegen. Die Enden der Litze 2 und der Leiterbahn 4 sind vor dem Verlöten verzinnt, wobei es auch denkbar ist, daß z. B. zwischen diesen Bereichen und der Auflage 6 eine Lötzinnschicht zwischengelegt ist. Die Endbereiche der Litze 2 sowie der Leiterbahn 4 werden von einem insbesondere elektrisch leitenden Druckelement 7 auf die Auflage 6 gedrückt, wobei der Druck dadurch erzeugt wird, daß die Auflage 6 sowie das Druckelement 7 innerhalb eines Gehäuses 8, das den Kontaktbereich 5 vollständig umschließt, angeordnet sind. Bei der Auflage 6 und/oder dem Druckelement 7 kann es sich auch um ein ein- oder mehrteiliges MID-Teil handeln, mittels dessen die Enden der Litze 2 und der Leiterbahn 4 miteinander kontaktiert werden. In diesem Fall genügt ggf. für die Kontaktierung die elektrisch leitende Auflage 6, so daß das Druckelement 7 entfallen kann, aber nicht muß. Im unteren Teil der Figur 1 ist gezeigt, daß die Auflage 6 mit einem verzinnten Bereich 9 versehen ist.

Bei Betrachtung des oberen Teiles der Figur 1 wird der Kontaktbereich 5 bzw. der gesamte von dem Gehäuse 8 umschlossene Bereich durch ein Induktionsfeld einer Induktionsspule geführt, so daß der verzinnte Bereich 9 (oder die verzinnten Enden der Litze 2 und der Leiterbahn 4) durch dieses Feld erhitzt und damit verlötet wird.

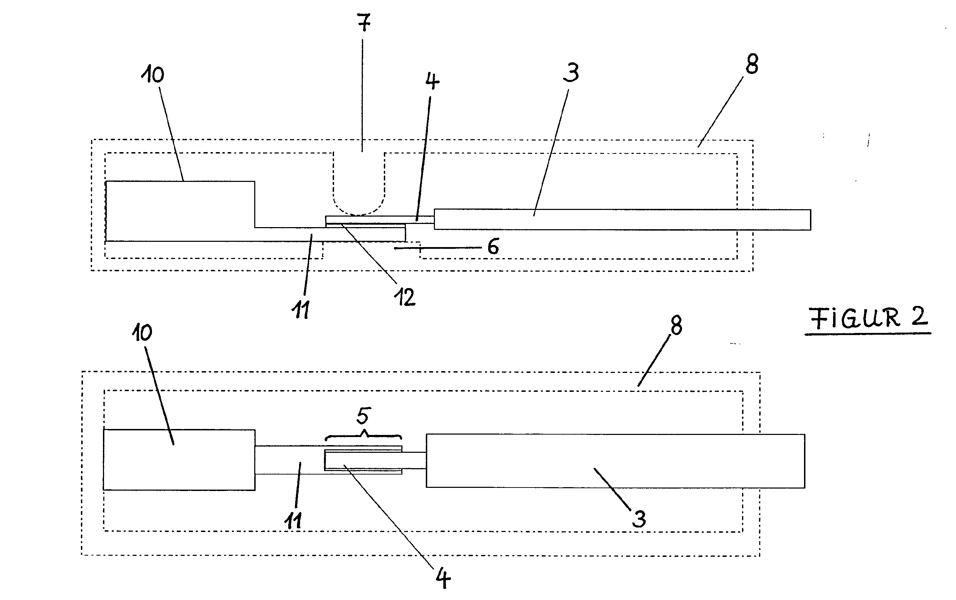

Figur 2 zeigt im oberen Teil in der Seitenansicht und im unteren Teil in der Draufsicht einen Steckverbinder, bei dem der eine Teil ein Stecker 10 (oder auch eine Buchse) mit einem Anschlußstück 11 ist, der mit der Leiterbahn 4 des Flachleiters 3 zu kontaktieren ist. Bei dieser Ausgestaltung überlappen sich der Endbereich der Leiterbahn 4 und der Endbereich des Anschlußstückes 11, wobei zwischen diesen beiden eine Zinnlage 12 (Lötzinn) zwischengelegt ist oder wenigstens der Endbereich der Leiterbahn 4 oder das Anschlußstück 11 verzinnt ist. Durch das mit dem Gehäuse 8 einteilig gestaltete Druckelement 7 werden die Kontaktpartner wieder unter Druck auf die Auflage 6, die ebenfalls Bestandteil des Gehäuses 8 ist, gedrückt. Auch hier wird die Zinnlage 12 durch das Induktionsfeld zum Schmelzen gebracht und verlötet damit die Endbereiche der Leiterbahn 4 und des Anschlußstückes 11 im Kontaktbereich 5. Innerhalb des Gehäuses 8 kann nur ein Stecker 10 vorhanden sein, wobei jedoch im Regelfall mehrere, parallel liegende Stecker 10 (oder Buchsen, Kontaktstifte oder dergleichen) angeordnet sind, die mit einer mehradrigen Leitung oder mit einem mehradrigen Flachleiter 3 zu verbinden sind.

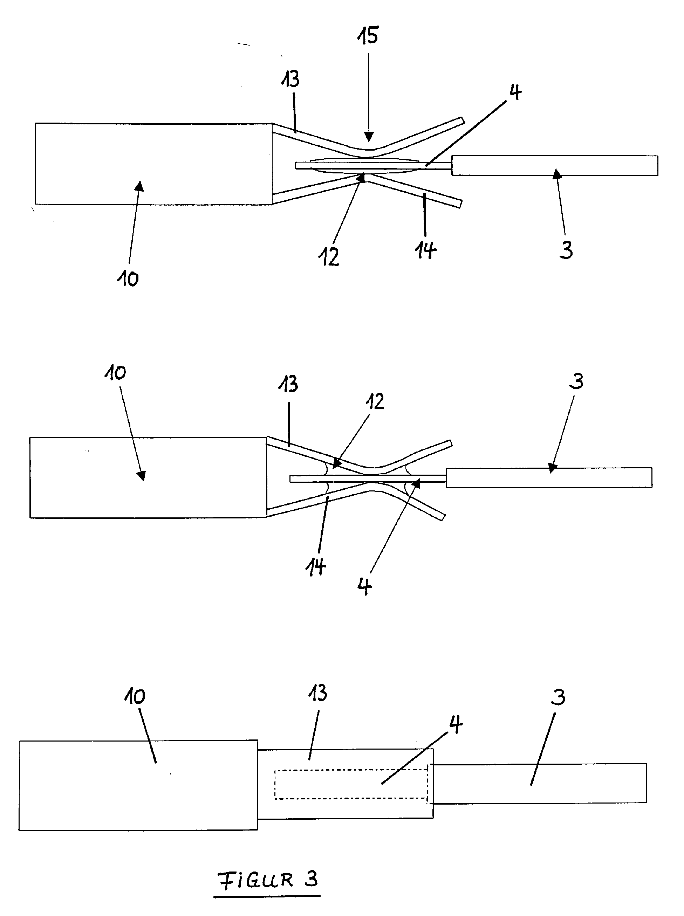

Figur 3 zeigt ebenfalls eine elektrische Verbindung zwischen einem Stecker und einem Flachleiter, wobei hier im Gegensatz zu der Ausgestaltung des Steckers 10 in Figur 2 der Stecker 10 zwei Andrücklaschen 13 und 14 aufweist, die in der Seitenansicht beispielsweise in etwa x-förmig am Ende des Steckers 10 angeordnet sind. Durch diese in etwa x-förmige Ausbildung der Andrücklaschen 13 und 14 wird ein Druckbereich 15 gebildet, der das zumindest eine vorbereitete Ende der Leiterbahn 4 des Flachleiters 3 aufnimmt. Die Vorbereitung der Leiterbahn 4 besteht zumindest darin, daß diese von ihrem Träger und gegebenenfalls einer vorhandenen Deckschicht aus Kunststoff befreit (abisoliert) wird und somit elektrisch kontaktierbar ist. Gegebenenfalls kann noch daran gedacht werden, daß im Druckbereich 15 und gegebenenfalls darum herum in Richtung der Andrücklasche 13 und/oder 14 die Zinnlage 12 eingebracht wird, wobei auch schon das Ende der Leiterbahn 4 verzinnt sein kann. Diese Zinnlage wird durch ein Induktionsfeld zum Schmelzen gebracht, so daß sich aufgrund der Adhäsionskräfte der Zinnlage 12 das dort befindliche Lotmaterial sich zwischen der Leiterbahn 4 und den Andrücklaschen 13 und 14 verteilt, wie dies in der mittleren Darstellung der Figur 3 gezeigt ist. Dadurch ergibt sich eine einfach herzustellende und zuverlässige elektrische Kontaktierung zwischen dem Stecker 10 und der zumindest einen Leiterbahn 4 des Flachleiters 3. In der unteren Darstellung der Figur 3 ist die fertige Kontaktierung noch einmal in der Draufsicht gezeigt. Dabei kann die Breite der Leiterbahn 4 gleich, kleiner oder auch größer der Breite der Andrücklaschen 13 und 14 sein.

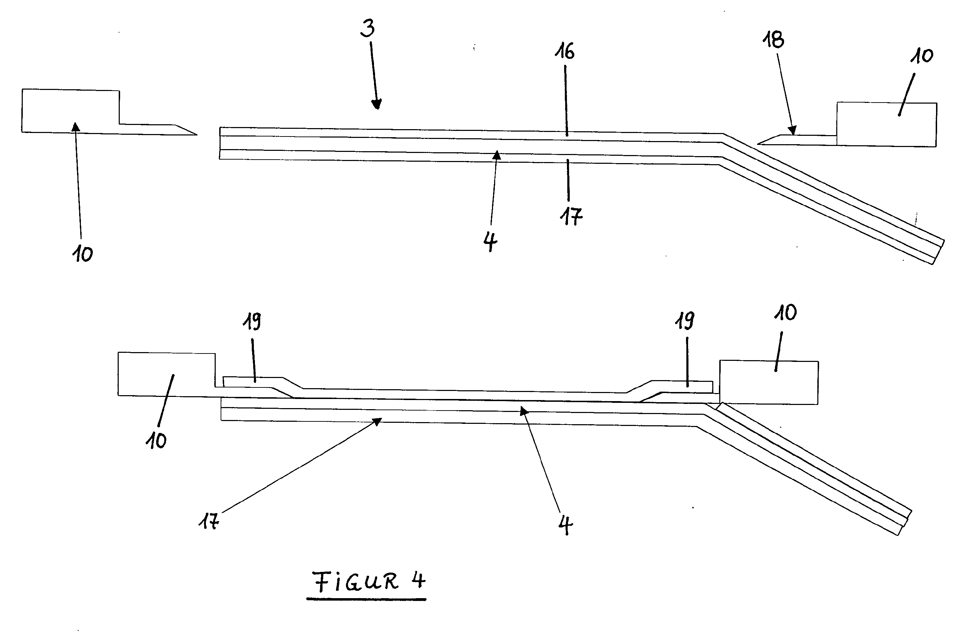

Figur 4 zeigt eine weitere Ausführung einer elektrischen Verbindung zwischen einem Stecker und einem Flachleiter. In dieser Figur 4 ist der Vollständigkeit halber noch einmal der Aufbau des Flachleiters 3 gezeigt, bei dem die Leiterbahn 4 (oder mehrere parallel zueinander angeordnete Leiterbahnen) mit einer Deckschicht 16 und einer Trägerschicht 17 (insbesondere beide aus dem gleichen Kunststoff) versehen sind. Da bei dieser Ausgestaltung die Leiterbahn 4 vollständig von den Schichten 16 und 17 umgeben ist, ist es für die Kontaktierung erforderlich, zumindest einen Teilbereich einer Schicht zu entfernen. Zu diesem Zweck weist der Stecker 10, bei dem es sich allgemein um ein Kontaktelement, also auch eine Buchse, handeln kann, eine Schneide 18 auf, die elektrisch leitend ausgebildet ist. Mit dieser Schneide 18 des Steckers 10 ist es möglich, entweder am Ende des Flachleiters 3 oder auch an einer beliebigen Stelle zwischendrin, z. B. die Deckschicht 16 aufzutrennen, so daß die elektrisch leitende Schneide 18 in einem Kontaktbereich 19 (siehe untere Darstellung der Figur 4) in Anlage kommt mit zumindest einer Leiterbahn 4. Je nach Kontaktierungserfordernis kann der Stecker 10 auch, entsprechend der Anordnung der parallelen Leiterbahnen 4, parallele Schneiden 18 aufweisen. Zur zuverlässigen elektrischen Verbindung der Schneide 18 mit der Leiterbahn 4 wird wieder im Kontaktbereich vorhandenes Lotmaterial zum Schmelzen gebracht. Bei der Ausgestaltung, die in Figur 4 gezeigt ist, weist in besonders vorteilhafter Weise die elektrisch leitende Schneide schon eine Verzinnung auf, da die Leiterbahn 4 vorher nicht verzinnt werden kann, da der Kontaktbereich noch mit der Deckschicht 16 oder der Trägerschicht 17 versehen ist. Auf diese beschriebene und in Figur 4 gezeigte Art und Weise ist es möglich, an beliebigen Stellen und in beliebiger Anzahl einen Flachleiter 3 mit Kontaktpartnern zu versehen. So ist es beispielsweise denkbar, daß an dem Stecker 10 wiederum ein Flachleiter angeordnet ist, wobei aber auch ein Litzenkabel oder dergleichen oder auch eine Leiterplatte angeordnet sein kann.

Es ist noch zu erwähnen, daß das Gehäuse 8 einteilig oder mehrteilig ist, wobei es in einer Ausführungsform aus zwei Hälften bestehen kann, die nach dem Zusammensetzen dauerhaft miteinander verbunden werden. Denkbar ist aber auch, daß der Endbereich des Kabels 1, des Flachleiters 3 bzw. des Steckers 10 mit Kunststoff umspritzt wird, um auf diese Art und Weise ein Gehäuse herzustellen.

## Patentansprüche

1. Verfahren zur Herstellung einer elektrischen Verbindung zwischen zumindest zwei elektrisch leitenden Kontaktpartnern, **dadurch gekennzeichnet, daß** die Kontaktpartner in einem Kontaktbereich zusammengebracht und im Kontaktbereich vorhandenes Lotmaterial, insbesondere Lötzinn, durch ein Induktionsfeld zum Schmelzen gebracht wird.

2. Verfahren nach Anspruch 1, **dadurch gekennzeichnet, daß** die Kontaktpartner innerhalb eines Gehäuses, insbesondere auf einer Auflage, zusammengebracht werden.

3. Verfahren nach Anspruch 1 oder 2, **dadurch gekennzeichnet, daß** die Kontaktpartner während des Lötvorganges einem Druck ausgesetzt sind.

4. Verfahren nach Anspruch 2 oder 3, **dadurch gekennzeichnet, daß** vor dem Löten zumindest um den Kontaktbereich herum das Gehäuse angebracht wird.

5. Verfahren nach Anspruch 4, **dadurch gekennzeichnet, daß** das Gehäuse im Kunststoffspritzverfahren hergestellt wird.

6. Verfahren nach einem der vorhergehenden Ansprüche, **dadurch gekennzeichnet, daß** zumindest ein Kontaktpartner vor dem Verlöten verzinnt wird.

7. Verfahren nach einem der vorhergehenden Ansprüche, **dadurch gekennzeichnet, daß** im Kontaktbereich ein Reservoir mit Lötzinn vorhanden ist.

8. Verfahren nach einem der vorhergehenden Ansprüche, **dadurch gekennzeichnet, daß** die Kontaktpartner im Kontaktbereich stumpf aneinander stoßen.

9. Verfahren nach einem der vorhergehenden Ansprüche, **dadurch gekennzeichnet, daß** sich die Kontaktpartner im Kontaktbereich überlappen.

10. Verfahren nach einem der vorhergehenden Ansprüche, **dadurch gekennzeichnet, daß** zumindest im Kontaktbereich der Kontaktpartner deren Kontaktierung über ein MID-Teil erfolgt.

11. Anwendung des Verfahrens, insbesondere nach einem der vorhergehenden Ansprüche, bei Steckverbindern in der Fahrzeugtechnik, insbesondere im Automobilbereich.

12. Anwendung des Verfahrens, insbesondere nach einem der vorhergehenden Ansprüche, bei der Verbindung von Leitungen, insbesondere von Flachbandleitungen, in der Fahrzeugtechnik, insbesondere im Automobilbereich.
